# EUROPEAN PATENT SPECIFICATION

(11) **EP 2 293 320 B1**
(45) Date of publication and mention of the grant of the patent: **15.08.2018**
(21) Application number: 10179524.3
(22) Date of filing: 29.11.2006
(51) Int. Cl.: C23C 4/06, C23C 4/08, C23C 14/34, C23C 4/134, C03C 17/09, C03C 17/245, C03C 17/36, C03C 17/40

(54) **METHOD FOR DEPOSITING A FILM CONTAINING TIN AND NIOBIUM**
VERFAHREN ZUR ABSCHEIDUNG EINES ZINN UND NIOB ENTHALTENDEN ÜBERZUGS
PROCÉDÉ DE DÉPÔT D'UN FILM CONTENANT DE L'ÉTAIN ET DU NIOBIUM

(30) Priority: 14.12.2005 US 300673
(43) Date of publication of application: 09.03.2011
(62) Divisional of application: 06838575.6
(73) Proprietor: Cardinal CG Company, Eden Prairie, MN 55344-4235 (US)
(72) Inventor: Hartig, Klaus, Avoca, WI WI 53506 (US)
(74) Representative: Howe, Steven

(56) References cited:
- WO-A-01/72652
- WO-A1-92/01081
- WO-A1-97/25450
- GB-A- 1 186 669
- JP-A- 8 060 349
- KIKUCHI N ET AL: "Electrical and mechanical properties of SnO2:Nb films for touch screens", VACUUM, vol. 66, no. 3-4, 16 February 2002 (2002-02-16), pages 365-371, XP002629399, ELSEVIER [GB] ISSN: 0042-207X, DOI: 10.1016/S0042-207X(02)00156-2

## Description

### FIELD OF THE INVENTION

The present invention provides a method that can be used to deposit thin films. More particularly, this invention provides a sputtering method using one or more rotatable cylindrical targets that can be used to deposit films that include particular materials.

### BACKGROUND OF THE INVENTION

Sputter deposition is a well-known process in the architectural and automotive glass industries. The process involves use of a sputtering target comprising material to be deposited onto a substrate. In D.C. sputtering, the target is commonly provided with a negative charge and a relatively positively charged anode is positioned within the sputtering chamber adjacent to the target. The chamber is then evacuated. By introducing a small amount of a desired gas into the chamber, a plasma of that gas can be established. Atoms in this plasma collide with the target, knocking material from the target and sputtering it onto the nearby substrate. It is known in the art to include a magnet behind the target to help shape the plasma and focus the plasma in an area adjacent a desired surface of the target (e.g., the target surface oriented toward the substrate). This process is generally referred to as magnetron sputtering.

Magnetron sputtering equipment and processes are known in the art. Useful sputtering equipment and processes are disclosed, for example, in U.S. Patent 4,166,018 (Chapin). Magnetron sputtering chambers are commercially available from a variety of sources (e.g., Airco and Leybold).

It would be desirable to provide sputtering targets and sputtering methods for depositing film comprising both tin and niobium. It would also be desirable to provide substrates coated with sputtered film comprising both tin and niobium.

The paper "Electrical and mechanical properties of SnO2:Nb films for touch screens" by Kikuchi et al, VACUUM, vol. 66, no. 3-4, describes the deposition of SnO₂:Nb films with 0-3.0 wt% Nb onto glass substrates by an RF sputtering process.

### SUMMARY

The scope of protection is defined by the independent claim, to which reference should now be made. Optional features are included in the dependent claims.

According to the claimed invention, there is provided a method of depositing a desired film comprising both tin and niobium, the method comprising: providing one or more rotatable cylindrical targets, each having an electrically conductive backing in the form of a rigid metal tube, each of the targets carrying a sputterable sub-oxide material consisting essentially of tin, niobium, and oxygen, wherein an atomic percentage of tin in the sputterable sub-oxide material is greater than 90 percent; positioning the one or more rotatable cylindrical targets in a sputtering chamber having a sputtering cavity containing an oxidizing gaseous atmosphere at a working pressure of between about 2 mTorr. (about 0.3kPa) and about 5 mTorr. (about 0.7kPa); and delivering electric charge to the one or more rotatable cylindrical targets to sputter deposit said desired film onto a large area glass substrate having a major surface oriented generally toward the one or more rotatable cylindrical targets, thereby either depositing said desired film directly upon said major surface of the substrate or directly upon a film previously deposited upon said major surface of the substrate.

A sputtering target comprising a sputterable material that includes both tin and niobium is also described. Tin optionally accounts for greater than about 90 atomic percent of the sputterable material, greater than about 95 percent, or even greater than about 97 percent. The target may be a rotatable cylindrical sputtering target comprising sputterable material in the form of a plasma and/or flame sprayed layer carried by a cylindrical backing tube. In some cases, the sputterable material comprises tin, niobium, and oxygen. The sputterable material may comprise tin, niobium, oxygen, and nitrogen. The target can optionally have a length of at least about 6 inches (about 15cm), at least about 12 inches (about 30cm), at least about 18 inches (about 45cm), at least about 24 inches (about 60cm), or even at least about 30 inches (about 75cm).

A method of depositing a desired film comprising both tin and niobium is also described. The method comprises providing a tin-containing sputtering target and a niobium-containing sputtering target. The respective sputterable material of these two targets can advantageously be different materials. Both targets are positioned in a sputtering chamber having a sputtering cavity in which a controlled environment can be established. Electric charge is delivered to both targets, either simultaneously or in succession, to establish a sputtering process so as to sputter deposit the desired film onto a substrate having a major surface oriented generally toward both targets, thereby either depositing the desired film directly upon the major surface of the substrate or directly upon a film previously deposited upon the major surface of the substrate.

A method of depositing a desired film comprising both tin and niobium is also described. The method comprises providing one or more targets, positioning the one or more targets in a sputtering chamber having a sputtering cavity containing an oxidizing gaseous atmosphere at a working pressure of between about 2 mTorr (about 0.3kPa). and about 5 mTorr. (about 0.7kPa), and delivering electric charge to the one or more targets to sputter deposit the desired film onto a glass substrate having a major surface oriented generally toward the one or more targets, thereby either depositing the desired film directly upon the major surface of the substrate or directly upon a film previously deposited upon the major surface of the substrate. The glass substrate optionally has a major dimension (e.g., a length) of at least about 24 inches (about 60cm).

A glass substrate bearing a sputtered film is also described. The sputtered film comprises tin and niobium, and the tin can optionally account for greater than 95 atomic percent of the sputtered film and the niobium accounts for less than 5 atomic percent of the sputtered film. The noted atomic percentages are relative to a total number of metal atoms of the sputtered film.

A multiple- pane insulating glass unit is also described. Here, the IG unit has spaced-apart first and second panes, an insulative gap exists between the first and second panes, the first pane has an inner surface facing toward the insulative gap, and the second pane has an outer surface facing away from the insulative gap. The inner surface of the first pane bears a low-emissivity coating that includes at least one silver-containing film (desirably a sputtered silver- containing film), and the outer surface of the second pane bears a sputtered film comprising both tin and niobium.

A method of producing a sputtering target is also described. The method comprises providing a first starting material in the form of a tube, the first starting material comprising tin. A second starting material comprising niobium is provided within an interior space defined by the tube. The method comprises a spraying technique selected from the group consisting of plasma spraying and flame spraying. The spraying technique involves introducing the tube and its contents (comprising the second starting material, which optionally is provided in a particulate form, such as in a powder form) into a plasma and/or flame such that the first and second starting materials are sprayed in molten form onto a backing tube.

Further multiple-pane insulating glass units are described. The IG unit has spaced-apart first and second panes, and an insulative gap exists between the first and second panes. A solar control coating is located on a #1 or #4 surface of the unit, and a low-emissivity coating is located on a #2 or #3 surface of the unit. The solar control coating comprises a sputtered film that includes both tin and niobium, and the low-emissivity coating comprises at least one silver-containing film (optionally a sputtered film).

A method of coating two opposed major surfaces of a sheet-like substrate (which optionally has a major dimension of at least about 12 inches (about 30cm)) is also described. The method comprises providing a sputtering line having a plurality of sputtering chambers connected in series along a path of substrate travel, which extends through the sputtering chambers. The sputtering line includes a plurality of upper targets located above the path of substrate travel, and a plurality of lower targets located below the path of substrate travel. The substrate is conveyed along the path of substrate travel. At least some of the lower targets are sputtered upwardly to deposit a solar control coating upon a first major surface of the substrate. The solar control coating comprises a film that includes both tin and niobium. At least some of the upper targets are sputtered downwardly to deposit a low-emissivity coating upon a second major surface of the substrate. The low-emissivity coating comprises at least one silver-containing film.

### BRIEF DESCRIPTION OF THE DRAWINGS

Figure 1 is a schematic cross-sectional side view of a substrate having a low-emissivity coating including a blocker film comprising tin and niobium;
Figure 2 is a schematic cross-sectional side view of a substrate having a low-emissivity coating including a blocker film comprising tin and niobium;
Figure 3 is a schematic cross-sectional side view of a substrate having a solar control coating comprising tin and niobium;
Figure 4 is a partially broken-away schematic cross-sectional side view of a multiple-pane insulating glass unit that includes a pane bearing a film comprising tin and niobium;
Figure 5 is a perspective view of a target;
Figure 6 is a schematic cross-sectional view of the target illustrated in Figure 5;
Figure 7 is a schematic side view of a spraying chamber used in certain methods;
Figure 8 is a schematic side view of a downward sputtering chamber having two upper rotatable targets;
Figure 9 is a schematic side view of an upward sputtering chamber having two lower rotatable targets;
Figure 10 is a schematic side view of a dual-direction sputtering chamber having two upper rotatable targets and two lower rotatable targets;
Figure 11 is a partially broken-away schematic cross-sectional side view of a multiple-pane insulating glass unit having both an exterior solar control coating and an interior low-emissivity coating; and
Figure 12 is a schematic side view of a sputtering line.

### DETAILED DESCRIPTION OF PREFERRED EMBODIMENTS

The following detailed description is to be read with reference to the drawings, in which like elements in different drawings have like reference numbers. The drawings, which are not necessarily to scale, depict selected embodiments and are not intended to limit the scope of the invention. Skilled artisans will recognize that the given examples have many alternatives that fall within the scope of the invention.

Sputtering targets and sputtering methods for depositing films that include tin and niobium are described. Also described is a substrate (e.g., a glass sheet) bearing a sputtered film comprising both tin and niobium. An IG unit having such a film is also described. Finally, a group of target manufacturing methods are described.

A wide variety of substrate types are suitable for use in the invention. In some embodiments, the substrate 10 is a sheet-like substrate having generally opposed first 12 and second 14 major surfaces. For example, the substrate can be a sheet of transparent material (i.e., a transparent sheet). The substrate, however, is not required to be a sheet, nor is it required to be transparent.

For many applications, the substrate will comprise a transparent (or at least translucent) material, such as glass or clear plastic. For example, the substrate is a glass sheet (e.g., a window pane) in certain embodiments. A variety of known glass types can be used, and soda-lime glass will commonly be preferred. In some cases, the substrate is part of a window, skylight, door, or other glazing. In certain embodiments, the substrate is a piece of aquarium glass, a plastic aquarium window, or a piece of greenhouse glass.

Substrates of various sizes can be used. Commonly, large-area substrates are used. Certain embodiments involve a substrate 10 having a major dimension (e.g., a length or width) of at least about 12 inches (about 30cm), preferably at least about 24 inches (about 60cm), perhaps more preferably at least about 30 inches (about 75cm) (e.g., between about 30 inches (about 75cm) and about 18 feet (about 5.5m)). In some embodiments, the substrate is a jumbo glass sheet having a length and/or width that is between about 9 feet (about 2.75m) and about 33 feet (about 10m), e.g., a glass sheet having a width of about 11.5 feet (about 3.5m) and a length of about 21.3 feet (about 6.4m). Substrates having a length and/or width of greater than about 33 feet (about 10m) are also anticipated. According to the claimed invention, the glass substrate has a major dimension of at least about 30 inches (about 75cm).

In some embodiments, the substrate 10 is a generally square or rectangular glass sheet. The substrate in these embodiments can have any of the dimensions described in the preceding paragraph and/or in the following paragraph.

Substrates of various thicknesses can also be used. In some embodiments, the substrate 10 (which can optionally be a glass sheet) has a thickness of about 1-5 mm. Certain embodiments involve a substrate 10 with a thickness of between about 2.3 mm and about 4.8 mm, and perhaps more preferably between about 2.5 mm and about 4.8 mm. In one particular embodiment, a sheet of glass (e.g., soda-lime glass) with a thickness of about 3 mm is used. In one group of embodiments, the thickness of the substrate (which can be glass, plastic, or another material) is between about 4 mm and about 20 mm. Thicknesses in this range, for example, may be useful for aquarium tanks (in which case, the substrate can optionally be glass or acrylic). When the substrate is float glass, it will in some cases have a thickness of between about 4 mm and about 19 mm. In another group of embodiments, the substrate is a thin sheet (e.g., of glass) having a thickness of less than about 4 mm, such as between about 0.35 mm and about 1.9 mm. Embodiments of this nature can optionally involve the substrate 10 being a sheet of display glass.

The sputtered film comprising tin and niobium can include other substantial components (e.g., oxygen and/or nitrogen), or it can consist essentially of tin and niobium. In some cases, the film is a metallic film comprising tin and niobium. In other cases, the film is an oxide film (optionally a suboxide film) comprising tin and niobium. The tin and niobium can be present in the film in any proportion desired. In some cases, the tin accounts for a major atomic percentage of the film material. For example, in some embodiments, the tin accounts for greater than about 90 percent, preferably greater than about 95 percent, and perhaps more preferably greater than about 97 percent of all the atoms of the sputtered film (and/or of all the metal atoms of the film), with the remainder being niobium and any other optional film material. In certain embodiments, the film consists essentially of tin, niobium, and oxygen, and the tin optionally accounts for greater than about 90 percent of the metal atoms in the film (i.e., taking the number of tin atoms divided by the total number of metal atoms in the film), preferably greater than about 95 percent, and more preferably greater than about 97 percent. In other embodiments, the film comprises tin, niobium, oxygen, and nitrogen, optionally together with one or more other materials.

In some embodiments, the sputtered film comprising tin and niobium is part of a low-emissivity coating. For example, this film can be a blocker layer or sacrificial layer deposited above or beneath an infrared-reflective film. The low- emissivity coating can be a "single" type low-emissivity coating wherein there is a single layer or thickness of infrared-reflective film, a "double" type low-emissivity coating wherein there are two layers or thicknesses of infrared-reflective film, etc. Alternatively, three or more layers or thicknesses of infrared-reflective film can be provided.

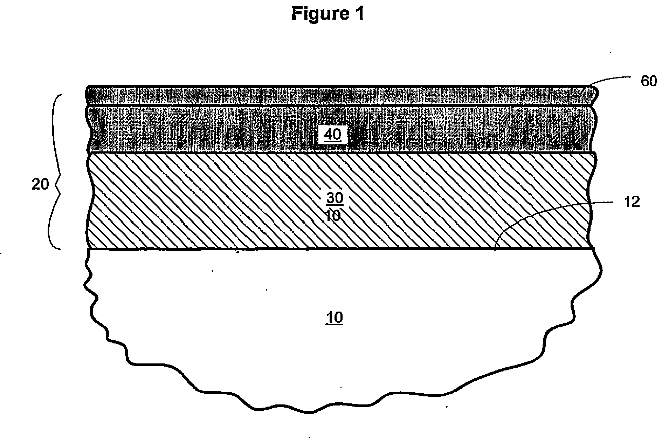

Figure 1 schematically illustrates a single type low-emissivity coating. In Figure 1, the illustrated substrate 10 has a surface (e.g., a major surface) 12 bearing the low-emissivity coating 20. The low-emissivity coating 20 comprises, in sequence outwardly, an inner coat 30, an infrared-reflective film 40, and a blocker film 60. Here, the blocker film 60 comprises tin and niobium. The infrared- reflective film can be silver, gold, copper, palladium, platinum, an alloy including one or more of these metals, or any other material that is highly reflective of infrared radiation. In certain embodiments, the infrared-reflective film is formed of silver, consists essentially of silver, or at least comprises silver. As shown in Figure 1 , a blocker film comprising tin and niobium can be located directly over an infrared-reflective film. A blocker film of this nature can additionally or alternatively be located directly beneath an infrared-reflective film. In Figure 1, there would commonly be an outer coat (not shown) over the illustrated blocker film 60.

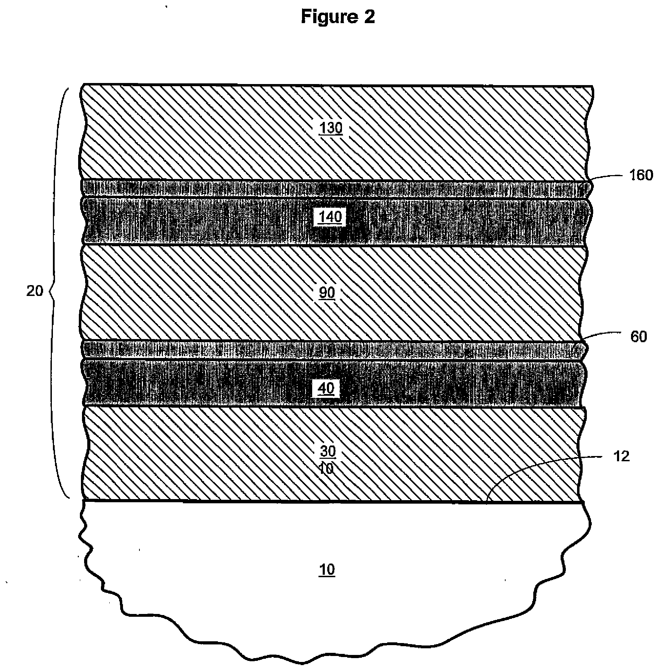

Figure 2 illustrates a substrate 10 bearing a double type low-emissivity coating 20. Here, the low-emissivity coating 20 comprises, in sequence outwardly, an inner coat 30, an infrared-reflective film 40, a blocker film 60, a middle coat 90, an infrared-reflective film 140, a blocker film 160, and an outer coat 130. Preferably, at least one of the blocker films 60 and 160 comprises tin and niobium. Alternatively or additionally, one or more of the coats 30, 90, 130 can comprise a film (such as an oxide, a nitride, or an oxynitride film) that includes both tin and niobium. In the illustrated embodiment, each blocker film is deposited over the infrared-reflective film. However, such blocker films can additionally or alternatively be deposited directly beneath the infrared-reflective films. In some cases, upper and lower blocker films each comprising tin and niobium are deposited respectively above and beneath each infrared-reflective film.

The film comprising tin and niobium preferably includes a major atomic tin percentage, e.g., relative to the total number of metal atoms in the film. In some embodiments, the tin accounts for greater than about 90 percent of the atoms in the film, preferably greater than about 95 percent, and perhaps more preferably greater than about 97 percent. In certain embodiments, the film consists essentially of tin, niobium, and oxygen, and the tin optionally accounts for greater than about 90 percent, preferably greater than about 95 percent, and perhaps greater than about 97 percent. One embodiment provides a substoichiometric film (e.g., a suboxide) comprising both tin and niobium.

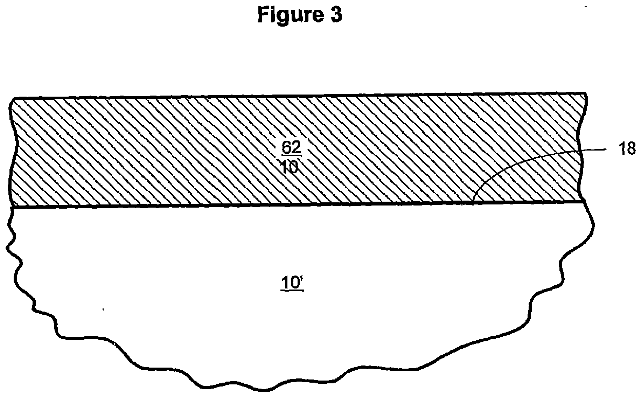

In certain embodiments, there is provided a solar control coating that includes a sputtered film comprising both tin and niobium. Figure 3 illustrates an exemplary embodiment of this nature wherein there is provided a substrate 10' bearing a solar control coating 62 that comprises both tin and niobium. The solar control coating 62 preferably includes a film wherein tin is present at a major atomic percentage In some embodiments, the tin accounts for greater than about 90 percent, preferably greater than about 95 percent, and perhaps more preferably greater than about 97 atomic percent. In certain embodiments, the solar control coating includes a film consisting essentially of tin, niobium, and oxygen, and the tin optionally accounts for greater than about 90 percent, preferably greater than about 95 percent, and perhaps more preferably greater than about 97 percent. In other embodiments, the film comprises tin, niobium, oxygen, and nitrogen.

The solar control coating (and/or a sputtered film forming a portion of such coating) preferably is deposited at a thickness of between about 200 angstroms (20nm) and about 3,500 angstroms (350nm), more preferably between about 250 angstroms (25nm) and about 2,500 angstroms (250nm), and perhaps optimally between about 350 angstroms (35nm) and 1,800 angstroms (180nm) (e.g., between about 350 angstroms (35nm) and about 1,200 angstroms (120nm)). These thicknesses can be for the coating 62 and/or for the film comprising tin and niobium.

The solar control coating can optionally include one or more iridescence- suppressing underlayers between the substrate and the film comprising tin and niobium. Additionally or alternatively, one or more overlayers can be provided, such as an overlying sputtered silica film, perhaps having a thickness of at least 100 angstroms (10nm).

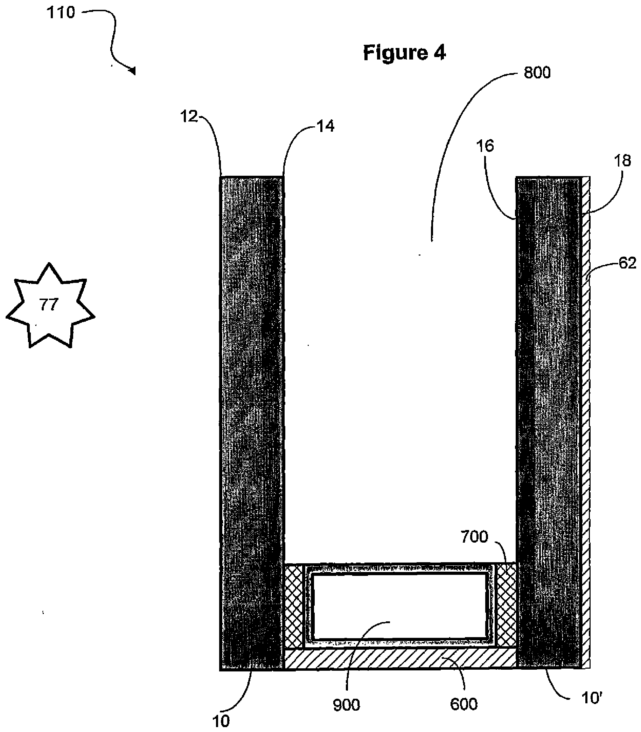

In some case, a substrate 10' bearing a solar control coating 62 is part of an insulating glass unit. A solar control coating 62 can be on one or more of the #1 , #2, #3, and #4 surface of a double-pane IG unit. For an IG unit having more than two panes, the coating 62 can be on any one or more of the major surfaces of the unit's panes. The coating 62 has the distinct advantage of being very durable. Therefore, it is particularly advantageous for use on an exterior (e.g., #1 or #4) surface of a double-pane IG unit. Figure 4 illustrates an exemplary multiple-pane insulating glass unit 110 bearing a solar control coating 62. Typically, an insulating glass unit 110 has an exterior pane 10 and an interior pane 10' separated by a between-pane space (or "an insulative gap") 800. A spacer 900 (which can optionally be part of a sash) is commonly provided to separate the panes 10 and 10'. The spacer can be secured to the inner surfaces of the panes using an adhesive 700. In some cases, an end sealant 600 is also provided. In the illustrated embodiment, the exterior pane 10 has an outer surface 12 (optionally being a #1 surface) and an inner surface 14 (optionally being a #2 surface). The interior pane 10' has an inner surface 16 (optionally being a #3 surface) and an outer surface 18 (optionally being a #4 surface). The pane 10 can be mounted in a frame (e.g., a window frame) such that outer surface 12 is exposed to an outdoor environment, while outer surface 18 is exposed to an indoor environment. Inner surfaces 14 and 16 are both exposed to the atmosphere in the between-pane space 800 of the insulating glass unit. In certain preferred embodiments, the solar control coating 62 is positioned on surface 18, which desirably is a #4 surface. Optionally, the surface 14 carries a low-emissivity coating comprising at least one silver-containing film.

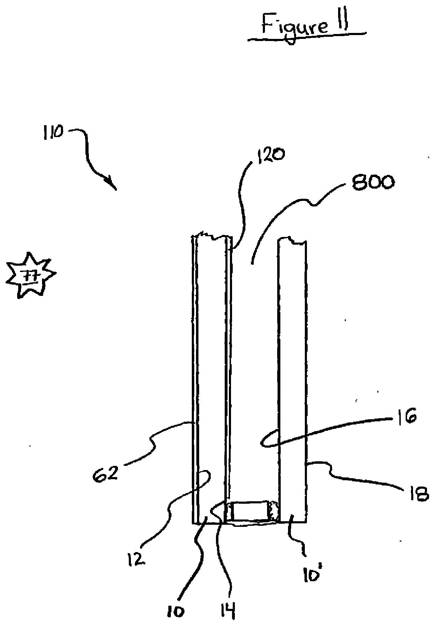

Figure 11 depicts another exemplary IG unit embodiment. Here, the #1 surface has the solar control coating 62, and the #2 surface has a low-emissivity coating 120 comprising at least one silver-containing film. This is representative of a group of embodiments wherein a solar control coating 62 is on the #1 or #4 surface of an IG unit, and wherein a low-emissivity coating 120 is on a #2 or #3 surface of the IG unit.

Other embodiments provide sputtering targets comprising a sputterable material that includes both tin and niobium. Such a sputtering target can be used to produce a film containing tin and niobium. The tin and niobium in the sputterable material of the target can be present in any proportion desired. In many cases, the tin accounts for a major percentage of the sputterable material (this can be a major atomic percentage and/or a major weight percentage). For example, in some embodiments, According to the claimed invention, the tin accounts for greater than about 90 atomic percent (relative to all the atoms of the sputterable material), and more preferably greater than about 95 atomic percent. In some embodiments, the tin accounts for greater than about 97% atomic percent. The sputterable material consists essentially of tin, niobium, and oxygen. According to the claimed invention, the target provides a suboxide sputterable material.

The sputtering target can be of any target type known in the art as long as it includes sputterable material comprising tin and niobium. In preferred cases, the targets are magnetron sputtering targets. There are two basic types of magnetron sputtering targets, namely planar targets and cylindrical targets. According to the claimed invention, the targets are rotatable cylindrical targets.

Planar targets tend to be relatively large, rectangular plates of sputterable target material. These plates are commonly attached to a conductive backing, which can be electrically connected to a power supply. The backing may also include a cooling system and a magnet used to generate a magnetic field to hold the sputtering plasma in a predefined area. Planar targets are well known in the present art.

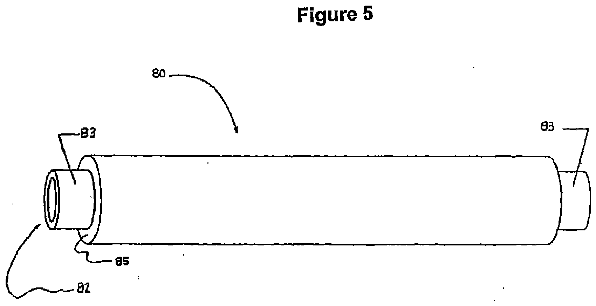

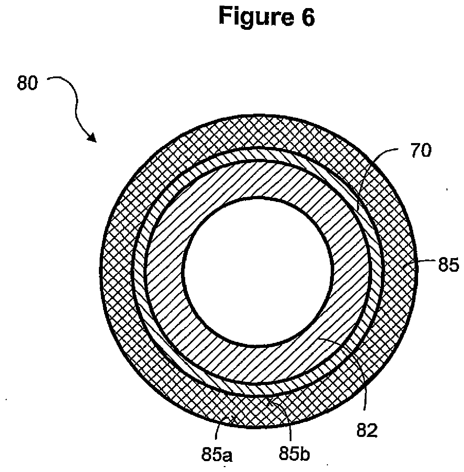

Cylindrical (e.g., rotatable) targets are gaining increased acceptance in the commercial application of thin films. Rotatable targets commonly take the form idealized in Figures 5 and 6. As shown in Figure 6, the rotatable target 80 generally includes a conductive backing 82, which is typically in the form of a rigid metal tube. This backing tube is commonly formed of an electrically conductive material. For example, preferred backing materials include aluminum, stainless steel, titanium, and copper. Use of a rigid backing tube allows a magnet to be positioned within the interior of the target, permitting the shape of the charged plasma adjacent the surface of the target to be more carefully controlled.

A layer of sputterable target material 85 including both tin and niobium is carried on this backing tube 82. The target material 85 may extend laterally from one end of the tube to the other. More commonly, a short length 83 at each end of the backing tube 82 extends laterally beyond the edges of the target material 85 to enable the target 80 to be mounted in a bay of a sputtering chamber. In some commercially available sputtering chambers, the chamber is provided with at least one pair of opposed end blocks, with one end block being used to hold each of the exposed lateral extensions 83 of the backing tube 82. Rotatable targets are also well known in the art.

The target 80 illustrated in Figure 6 includes a relatively thin optional bonding layer 70 between the backing tube 82 and the target material 85. If so desired, the target material 85 can be formed directly upon the backing tube 82. However, a bonding layer 70 is advantageous in some cases to help insure that the target material 85 is securely adhered to the backing tube 82. The bonding layer 70, when provided, may be conductive and may have a coefficient of thermal expansion between that of the backing tube and the sputterable material. This may reduce target degeneration that can occur during heating and cooling as a result of the different thermal expansion rates of the backing tube 82 and the target material 85. Bonding layers of this nature are well known in the art as well.

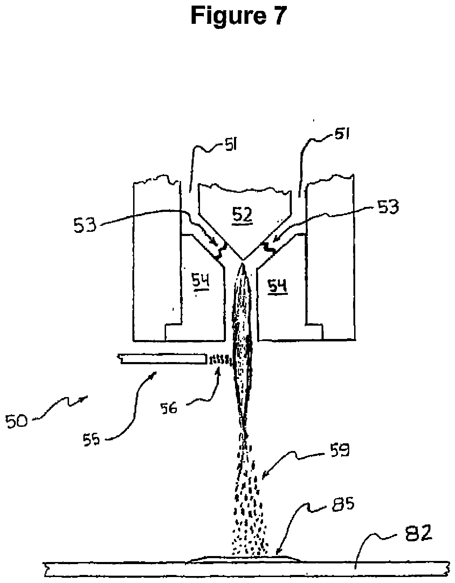

Methods of making a sputtering target having sputterable material comprising both tin and niobium are provided. In some cases, a plasma spray and/or flame spray method is employed to produce a sputtering target of this nature. In certain embodiments, tabular tin wire(s) is/are fed to the flame/plasma, and such tin tube is filled with powder of niobium, niobium oxide, niobium nitride, or mixtures thereof, the percentages of such starting materials being selected such that the spraying process gives the target a sputterable material in desired relative percentages. The gas mix used during the spraying process can be adjusted, as known to skilled artisans, to optimize the spraying process for best results (e.g., to achieve a desired density, homogeneity, and extent of any reaction (oxidizing, nitriding, etc.). One group of embodiments provides a rotatable cylindrical sputtering target comprising a plasma and/or flame sprayed layer (comprising tin and niobium) carried by a cylindrical backing tube. In some embodiments, the tin and niobium targets are formed by plasma and/or flame spraying molten (i.e., heat softened) tin and niobium material onto a target backing. With reference to Figure 7, a plasma gun 50 (or "jet") communicates with a gas supply (not shown) from which plasma gas flows through a channel 51. leading past a cathode 52 and an anode 54. The plasma gas, which may comprise one or more different types of gas (e.g., argon, hydrogen, nitrogen, helium), flows past the cathode 52 and the anode 54. One or more electric arcs 53 are generated between the cathode 52 and the anode 54. These arcs 53 cause the gas to heat up and reach very high temperatures, which in turn results in gas dissociation and plasma formation. During this process, the rapid expansion of plasma gas causes a very hot stream of plasma to rapidly accelerate from the fixed interior volume of the plasma gun.

Tin and niobium particles (and/or tin oxide particles and/or niobium oxide particles) 56 can be fed into this high temperature plasma stream, typically from a powder and/or wire supply 55 mounted near the outlet of the plasma gun. This causes a molten stream of particles 59 to be accelerated toward the target backing 82. The molten material that accumulates on the target backing 82 forms a coating of target material 85. During plasma spraying, the target backing 82 can be rotated and translated laterally in a back and forth manner to assure the target base 82 is uniformly coated with target material 85. Useful starting particles may, for example, have an average particle size in the range of about 1-60 micrometers, perhaps in the range of about 1-20 micrometers.

The starting particles can be fed into a plasma flame, which may have a temperature of at least about 2000° C. The plasma spraying can optionally be performed in a processing atmosphere that is substantially free of oxygen (i.e., free of oxygen and oxygen-containing compounds). Argon can be used quite advantageously as a primary plasma gas in the present plasma spraying methods. It is to be understood that use herein of the term "primary plasma gas" is meant to refer to the gas that is present in the greatest concentration in a processing environment. Argon is a desirable plasma gas since it readily forms a plasma. In fact, even if a secondary plasma gas is used with argon during the actual plasma spraying, it may be preferable to start up the plasma using pure argon, since argon so easily forms a plasma. Argon is also inert to virtually all spray materials. Moreover, it tends to be less degenerative to plasma spraying hardware (e.g., the nozzle) than other gases.

While argon tends to be the favored primary plasma gas, in many cases it is desirable to use argon with a secondary plasma gas that will increase plasma energy. Use herein of the term "secondary plasma gas" is meant to refer to a gas that is present in a processing environment in a lesser concentration than the primary plasma gas. For example, it may be desirable to achieve particle temperatures on the order of at least 2000°C, and perhaps above 2500°C. When it is desired to produce such high temperatures, it is preferable to use hydrogen and/or helium as a secondary plasma gas.

In one group of embodiments, a target is produced by spraying (plasma and/or flame) technique in which a tube comprising tin is used as a first starting material. A second starting material comprising niobium can also be used. For example, a particulate form of the second starting material can be disposed within an interior space (e.g., lumen) defined by the tube.

The tube can optionally be a metallic material comprising tin and the niobium-containing material can be a powder disposed inside the tube.

Sputtering chambers and sputtering methods are also provided in certain embodiments. Here, there is provided a sputtering chamber and/or sputtering method that includes one or more targets at least one of which comprises tin and at least one of which comprises niobium. In some embodiments, each target comprises tin and niobium. That is, each target comprises a sputterable material that includes both tin and niobium. These targets can be tin and niobium containing targets produced by plasma and/or flame spraying tin and niobium containing particles onto a target base, as described above, or they can be tin and niobium containing targets produced by other methods (hot isostatic pressing, casting, etc.). The target(s) can be sputtered to provide a film comprising both tin and niobium.

In some embodiments, there is provided a sputtering chamber and/or sputtering method involving a target that includes a tin-containing sputterable material and another target that includes a niobium-containing sputterable material. In one group of these embodiments, the niobium-containing sputterable material is selected from the group consisting of niobium suboxide, niobium oxynitride, and niobium nitride. In some cases, one target comprises tin but no niobium, and another target comprises niobium but no tin. Here, tin is sputtered from one target, and niobium is sputtered from another target. Such targets can, for example, be co-sputtered (e.g., in a shared gaseous atmosphere, such as an oxidizing atmosphere or an inert atmosphere) to produce a film comprising both tin and niobium. The sputtering can be done by D.C. sputtering, pulsed D.C. sputtering, alternating pulsed D.C. sputtering, or biased A.C. sputtering. According to the claimed invention, a D.C. sputtering process is used. Reactive or semi-reactive sputtering techniques can be used to control the properties and/or composition of the resulting film by selecting a gas mixture that includes one or more gases selected from the group consisting of helium, nitrogen, oxygen, and argon. Other gases can be used in other embodiments. In one group of embodiments, the sputtering involves heating the substrate during and/or prior to the sputtering. Any sputtering method disclosed herein can optionally be carried out using a gaseous sputtering atmosphere that comprises nitrogen and/or helium. In one example, the gas mix includes oxygen and nitrogen, optionally with oxygen being used at a higher percentage than nitrogen.

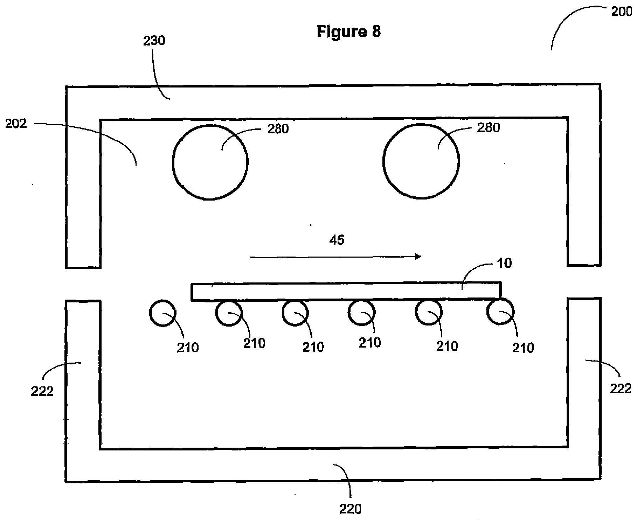

Figures 8-10 and 12 illustrate exemplary sputtering chambers and sputtering methods. Figure 8 illustrates an exemplary downward sputtering chamber and downward sputtering method. The sputtering chamber 200 of Figure 8 includes a base (or "floor") 220, a plurality of side walls 222, and a ceiling (or "top lid" or "cover") 230, together bounding a sputtering cavity 202. Two upper targets 280 are mounted above the path of substrate travel 45. The substrate 10 is conveyed along the path of substrate travel 45 during film deposition, optionally over a plurality of spaced-apart transport rollers 210. In Figure 8, two upper targets are provided, although this is by no means required. For example, a single target could alternatively be used in the chamber. Moreover, the chamber can include one or more upper planar targets, although cylindrical targets are shown. In some embodiments, each upper target 280 has a sputterable material comprising both tin and niobium. In certain embodiments, one upper target includes a tin-containing sputterable material and another upper target includes a niobium-containing sputterable material.

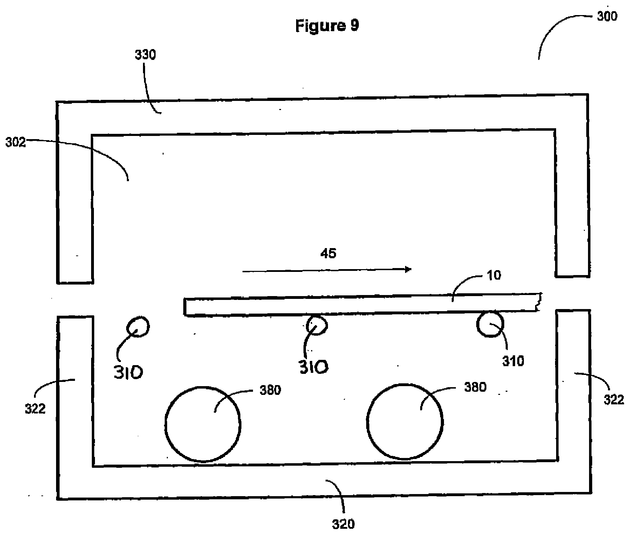

Figure 9 illustrates an exemplary upward sputtering chamber and upward sputtering method. The sputtering chamber 300 of Figure 9 also includes a base (or "floor") 320, a plurality of side walls 322, and a ceiling (or "top lid" or "cover") 330, together bounding a sputtering cavity 302. Two lower targets 380 are mounted beneath the path of substrate travel 45. The substrate 10 is conveyed along the path of substrate travel 45 during film deposition, optionally over a plurality of spaced-apart transport rollers 210. In Figure 9, two lower targets are provided, although this is by no means required. For example, a single target could alternatively be used in the chamber. Moreover, the chamber can include one or more lower planar targets, although cylindrical targets are shown. In some embodiments, each lower target 380 has a sputterable material comprising both tin and niobium. In certain embodiments, one lower target includes a tin-containing sputterable material and another lower target includes a niobium-containing sputterable material.

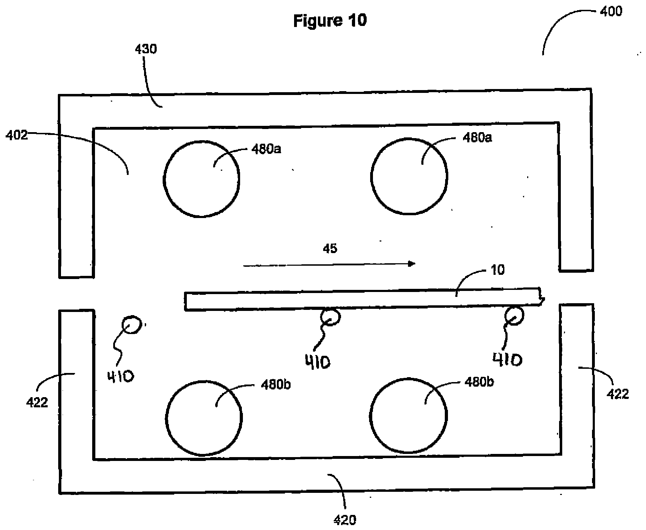

Figure 10 illustrates an exemplary dual direction sputtering chamber 400 and dual direction sputtering methods. Dual direction (and upward direction) sputtering chambers are described in U.S. patent applications 09/868,542 (US Patent No.6964731), 10/911,155 (US Patent No. 7294403), and 10/922,719 (US Patent No 7491301). The illustrated sputtering chamber 400 includes a base (or "floor") 420, a plurality of side walls 422, and a ceiling (or "top lid" or "cover") 430, together bounding a sputtering cavity 402. Two upper targets 480a are mounted above the path of substrate travel 45 and two lower targets 480b are mounted below the path of substrate travel. The substrate 10 is conveyed along the path of substrate travel 45 during film deposition, optionally over a plurality of spaced-apart transport rollers 310. The upper targets 480a and lower targets 480b can optionally be sputtered simultaneously to deposit one film on one surface of the substrate and another film on the opposite surface. In some embodiments, each lower target 480b has a sputterable material comprising both tin and niobium. In certain embodiments, one lower target includes a tin- containing sputterable material and another lower target includes a niobium- containing sputterable material.

Thus, various methods for sputter depositing a film comprising tin and niobium are provided. In certain embodiments, the method includes providing a tin-containing target and a niobium-containing target. In some cases, the tin- containing target includes tin but no niobium, and the niobium-containing target includes niobium but no tin. For example, an essentially pure tin target can be used in combination with an essentially pure niobium target. Both targets can be positioned in a sputtering chamber having a sputtering cavity in which a controlled environment can be established. An electric charge can then be delivered to both targets, either simultaneously or in succession, to sputter deposit a tin and niobium containing film onto a substrate or onto an underlying film previously deposited on the substrate.

In other embodiments, the method includes providing one or more targets each having a sputterable material comprising both tin and niobium. In these embodiments, each target comprises tin and niobium. Such a target can comprise sputterable metallic material, sputterable oxide material (such as a sputterable suboxide material), sputterable nitride material, or sputterable oxynitride material. According to the claimed invention, the targets carry a sputterable suboxide material. The one or more targets is/are positioned in a sputtering chamber having a sputtering cavity in which a controlled environment can be established. An electric charge is delivered to the one or more targets, thereby sputter depositing onto the substrate a film comprising both tin and niobium. The present sputtering techniques are preferably carried out in a gaseous atmosphere at a working pressure of between about 2 mTorr. (about 0.3kPa) and about 5 mTorr (about 0.7kPa).

When it is desired to deposit a metallic film containing tin and niobium, each target preferably consists essentially of metallic sputterable material. Each such metallic target can be sputtered in an inert atmosphere, for example an argon atmosphere. Some related embodiments involve sputtering from one or a series of targets each carrying a metallic sputterable material consisting essentially of tin and niobium.

On the other hand, when it is desired to deposit an oxide film comprising tin and niobium, each target can be a metallic target that is sputtered in an oxidizing atmosphere. Each such target can alternatively or additionally have an oxygen- containing sputterable material. According to the claimed invention, each target carries a sputterable material consisting essentially of tin, niobium and oxygen, the sputterable material being a suboxide. In such targets, the atomic percentage of tin is advantageously greater than about 90%, greater than about 95%, or even greater than about 97%.

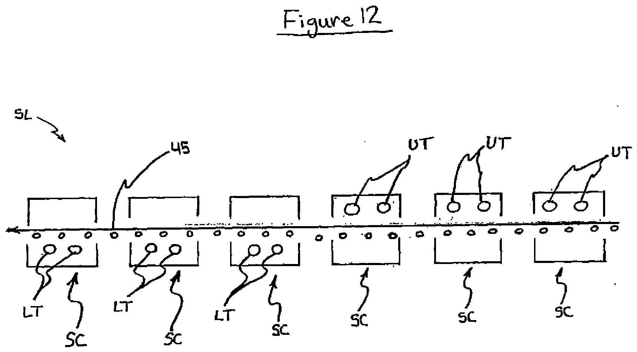

Figure 12 depicts a sputtering line SL having a plurality of sputtering chambers SC connected in series along a path of substrate travel 45 extending through the sputtering chambers. The sputtering line shown in Figure 12 includes a plurality of upper targets UT located above the path of substrate travel 45 and a plurality of lower targets LT located below the path of substrate travel. One or more of the chambers SC can optionally be dual-direction chambers (e.g., sputter- up/sputter-down chambers). Here, the method involves conveying the substrate along the path of substrate travel, upwardly sputtering at least some of the lower targets to deposit a solar control coating upon a first major surface of the substrate (the solar control coating comprising a film that includes both tin and niobium), and downwardly sputtering at least some of the upper targets to deposit a low-emissivity coating upon a second major surface of the substrate (the low- emissivity coating comprising at least one silver-containing film). These coatings can be deposited directly upon the respective first and second major surfaces, or they can be deposited over previously deposited films.

The present method desirably involves fully applying both coatings in a single pass of the substrate along the sputtering line (the substrate preferably being maintained in a constant orientation wherein the first major surface is downwardly facing and the second major surface is upwardly facing, e.g., at all times during conveyance of the substrate along the sputtering line). The present method can be used to particular advantage, in that during a single pass of the substrate along the sputtering line both sides of the substrate can be coated, in particular with a durable (hard) coating deposited by an upward sputtering method (which may involve the hard coating being conveyed directly over, and in contact with, transport rollers) and a soft (silver-containing) coating deposited by a downward sputtering method. The resulting coated substrate (which can optionally be a glass sheet having a major dimension of at least about 12 inches (about 30cm)) can be used to particular advantage by incorporating into an IG unit embodiment wherein either the inboard or outboard pane of the IG unit bears both the solar control coating 62 and the low-emissivity coating 120.

While a preferred embodiment of the present invention has been described, it should be understood that various changes, adaptations and modifications may be made therein without departing from the scope of the appended claims.

Examples of the disclosure can be described with reference to the following numbered clauses, with preferred features laid out in the dependent clauses:
1. A sputtering target comprising a sputterable material that includes both tin and niobium.
2. The sputtering target of clause 1 wherein the target is a rotatable cylindrical sputtering target and the sputterable material is present in the form of a plasma and/or flame sprayed layer carried by a cylindrical backing tube.
3. The sputtering target of clause 1 wherein tin accounts for greater than about 90 atomic percent of the sputterable material.
4. The sputtering target of clause 1 wherein tin accounts for greater than about 95 atomic percent of the sputterable material.
5. The sputtering target of clause 1 wherein the sputterable material comprises tin, niobium, and oxygen.
6. The sputtering target of clause 5 wherein the sputterable material comprises tin, niobium, oxygen, and nitrogen.
7. The sputtering target of clause 1 wherein the sputterable material consists essentially of tin and niobium.
8. The sputtering target of clause 1 wherein the target has a length of at least about 12 inches (about 30cm).
9. A method of depositing a desired film comprising both tin and niobium, the method comprising providing a tin-containing sputtering target and a niobium- containing sputtering target, positioning both targets in a sputtering chamber having a sputtering cavity in which a controlled environment can be established, and delivering electric charge to both targets, either simultaneously or in succession, to establish a sputtering process so as to sputter deposit said desired film onto a substrate having a major surface oriented generally toward both targets, thereby either depositing said desired film directly upon said major surface of the substrate or directly upon a film previously deposited upon said major surface of the substrate.
10. The method of clause 9 wherein said sputtering process is selected from the group consisting of D.C. sputtering and A.C. sputtering.
11. The method of clause 10 wherein said sputtering process is a pulsed D.C. sputtering technique.
12. The method of clause 10 wherein said sputtering process is a biased A.C. sputtering technique.
13. The method of clause 9 wherein the method involves a co-sputtering technique such that the niobium-containing target and the tin-containing target are sputtered simultaneously.
14. The method of clause 9 wherein said desired film is an oxide film, and either said sputter depositing involves a reactive sputter deposition technique carried out in an oxidizing atmosphere or oxygen is contained in one or both of the tin- containing target and the niobium-containing target.
15. The method of clause 9 wherein said sputter depositing is carried out such that said desired film comprises tin, niobium, oxygen, and nitrogen.
16. The method of clause 9 wherein said sputter depositing is carried out such that said desired film consists essentially of tin, niobium, and oxygen.
17. The method of clause 9 wherein said sputter depositing is carried out such that said desired film comprises greater than about 95 atomic percent tin and less than about 5 atomic percent niobium, said percentages being relative to a total number of metal atoms of said desired film.
18. The method of clause 9 wherein said sputter depositing is carried out in a gaseous atmosphere at a working pressure of between about 2 mTorr. (about 0.3kPa) and about 5 mTorr (about 0.7kPa).
19. The method of clause 9 wherein the major dimension of the glass sheet is at least about 12 inches (about 30cm).
20. The method of clause 9 wherein the major dimension of the glass sheet is at least about 30 inches (about 30cm).
21. A method of depositing a desired film comprising both tin and niobium, the method comprising providing one or more targets, positioning said one or more targets in a sputtering chamber having a sputtering cavity containing an oxidizing gaseous atmosphere at a working pressure of between about 2 mTorr. (about 0.3kPa) and about 5 mTorr. (about 0.7kPa), and delivering electric charge to said one or more targets to sputter deposit said desired film onto a glass substrate having a major surface oriented generally toward said one or more targets, thereby either depositing said desired film directly upon said major surface of the substrate or directly upon a film previously deposited upon said major surface of the substrate, wherein the glass substrate has a major dimension of at least about 24 inches (about 60cm).
22. The method of clause 21 wherein said sputter depositing is carried out such that said desired film has a thickness of between 200 angstroms (20nm) and 3,500 angstroms (350nm).
23. The method of clause 22 wherein said thickness is between 250 angstroms (25nm) and 2,500 angstroms (250nm).
24. The method of clause 23 wherein said thickness is between 350 angstroms (35nm) and 1,800 angstroms (180nm).
25. The method of clause 21 wherein said sputter depositing is carried out such that said desired film comprises tin, niobium, oxygen, and nitrogen.
26. The method of clause 21 wherein said sputter depositing is carried out such that said desired film consists essentially of tin, niobium, and oxygen.
27. The method of clause 21 wherein said sputter depositing is carried out such that said desired film comprises greater than about 95 atomic percent tin and less than about 5 atomic percent niobium, said percentages being relative to a total number of metal atoms of said desired film.
28. A glass substrate bearing a sputtered film, the sputtered film comprising tin and niobium, wherein the tin accounts for greater than 95 atomic percent of the sputtered film and the niobium accounts for less than 5 atomic percent of the sputtered film, said percentages being relative to a total number of metal atoms of the sputtered film.
29. The glass substrate of clause 28 wherein the tin accounts for greater than 97 atomic percent of the sputtered film and the niobium accounts for less than 3 atomic percent of the sputtered film, said percentages being relative to a total number of metal atoms of the sputtered film.
30. The glass substrate of clause 28 wherein the sputtered film comprises tin, niobium, oxygen, and nitrogen.
31. The glass substrate of clause 28 wherein the sputtered film consists essentially of tin, niobium, and oxygen.
32. The glass substrate of clause 28 wherein the sputtered film is part of a low- emissivity coating on the glass substrate.
33. The glass substrate of clause 28 wherein the substrate is part of a multiple- pane insulating glass unit.
34. The glass substrate of clause 33 wherein the sputtered film is located on a #4 surface of the insulating glass unit.
35. A multiple-pane insulating glass unit having spaced-apart first and second panes, wherein an insulative gap exists between the first and second panes, the first pane having an inner surface facing toward the insulative gap, said inner surface of the first pane bearing a low-emissivity coating that includes at least one silver-containing film, the second pane having an outer surface facing away from the insulative gap, said outer surface of the second pane bearing a sputtered film comprising both tin and niobium.
36. The insulating glass unit of clause 35 wherein an outer surface of said first pane is a #1 surface exposed to an outdoor environment, and wherein said outer surface of the second pane is a #4 surface exposed to an indoor environment.
37. The insulating glass unit of clause 35 wherein the sputtered film comprises tin, niobium, oxygen, and nitrogen.
38. The insulating glass unit of clause 35 wherein the sputtered film consists essentially of tin, niobium, and oxygen.
39. The insulating glass unit of clause 35 wherein the sputtered film comprises greater than about 95 atomic percent tin and less than about 5 atomic percent niobium, said percentages being relative to a total number of metal atoms of the sputtered film.
40. A method of producing a sputtering target, the method comprising providing a first starting material in the form of a tube, the first starting material comprising tin, wherein a second starting material comprising niobium is provided within an interior space defined by said tube, the method comprising a spraying technique selected from the group consisting of plasma spraying and flame spraying, said spraying technique involving introducing such tube and its contents into a plasma and/or flame such that said first and second starting materials are sprayed in molten form onto a backing tube.
41. The method of clause 40 wherein the tube is formed of a metallic material comprising tin, and said second starting material is disposed within said interior space of the tube in a particulate form.
42. A multiple-pane insulating glass unit having spaced-apart first and second panes, wherein an insulative gap exists between the first and second panes, wherein a solar control coating is located on a #1 or #4 surface of the unit, and wherein a low-emissivity coating is located on a #2 or #3 surface of the unit, the solar control coating comprising a sputtered film that includes both tin and niobium, the low-emissivity coating comprising at least one silver-containing film.
43. The insulating glass unit of clause 42 wherein the solar control coating is located on a #1 surface of the unit, and wherein the low-emissivity coating is located on a #2 surface of the unit.
44. A method of coating two opposed major surfaces of a sheet-like substrate having a major dimension of at least about 12 inches (about 30cm), the method comprising:
   a) providing a sputtering line having a plurality of sputtering chambers connected in series along a path of substrate travel extending through the sputtering chambers, the sputtering line including a plurality of upper targets located above the path of substrate travel and a plurality of lower targets located below the path of substrate travel;
   b) conveying the substrate along the path of substrate travel;
   c) upwardly sputtering at least some of the lower targets to deposit a solar control coating upon a first major surface of the substrate, the solar control coating comprising a film that includes both tin and niobium; and d) downwardly sputtering at least some of the upper targets to deposit a low-emissivity coating upon a second major surface of the substrate, the low-emissivity coating comprising at least one silver-containing film.

## Claims

1. A method of depositing a desired film comprising both tin and niobium, the method comprising:
providing one or more rotatable cylindrical targets, each having an electrically conductive backing in the form of a rigid metal tube, each of the targets carrying a sputterable sub-oxide material consisting essentially of tin, niobium, and oxygen, wherein an atomic percentage of tin in the sputterable sub-oxide material is greater than 90 percent;
positioning the one or more rotatable cylindrical targets in a sputtering chamber having a sputtering cavity containing an oxidizing gaseous atmosphere at a working pressure of between 0.3 kPa and 0.7 kPa (2mTorr and 5 mTorr); and
delivering electric charge to the one or more rotatable cylindrical targets to sputter deposit said desired film onto a large area glass substrate having a major surface oriented generally toward the one or more rotatable cylindrical targets, thereby either depositing said desired film directly upon said major surface of the substrate or directly upon a film previously deposited upon said major surface of the substrate,
wherein the large area glass substrate has a major dimension of at least 30 inches (75cm); and
wherein delivering the electric charge comprises delivering the electric charge to establish a D.C. sputtering process.

2. The method of claim 1, wherein said sputter depositing is carried out such that said desired film has a thickness of between 200 angstroms (20nm) and 3,500 angstroms (350nm), preferably between 250 angstroms (25nm) and 2,500 angstroms (250nm) and more preferably between 350 angstroms (35nm) and 1,800 angstroms (180nm).

3. The method of claim 1, wherein said sputter depositing is carried out such that said desired film comprises tin, niobium, oxygen, and nitrogen, or such that said desired film consists essentially of tin, niobium, and oxygen.

4. The method of claim 1, wherein said sputter depositing is carried out such that said desired film comprises greater than about 95 atomic percent tin and less than about 5 atomic percent niobium, said percentages being relative to a total number of metal atoms of said desired film.

5. The method of claim 1, wherein the desired film defines or is part of a solar control coating, the desired film having a thickness of between 350 angstroms (35nm) and 1800 angstroms (180nm).

6. The method of claim 5, wherein the solar control coating is on an exterior surface of an insulated glass unit, the exterior surface arranged to be exposed to an exterior environment.

7. The method of claim 1, wherein the large area glass substrate comprises soda-lime glass with a thickness of between about 1 mm and 5 mm.

8. The method of claim 1, wherein the desired film is deposited above and/or below an infrared reflective film.

9. The method of claim 1, wherein the sputterable material includes greater than about 95 atomic percent tin, preferably greater than about 97 atomic percent tin.

## Patentansprüche

1. Verfahren zum Ablagern eines erwünschten Films, sowohl Zinn als auch Niob umfassend, wobei das Verfahren Folgendes umfasst:
Bereitstellen von einem oder mehreren drehbaren zylindrischen Zielen, jeweils mit einer elektrisch leitfähigen Beschichtung in der Form einer starren Metallröhre, wobei jedes der Ziele ein spritzbares Suboxidmaterial trägt, das im Wesentlichen aus Zinn, Niob und Sauerstoff besteht, wobei ein prozentualer Atomanteil von Zinn in dem spritzbaren Suboxidmaterial über 90 Prozent beträgt;
Positionieren des einen oder der mehreren drehbaren zylindrischen Ziele in einer Spritzkammer mit einem Spritzhohlraum, der eine oxidierende Gasatmosphäre enthält, bei einem Arbeitsdruck von zwischen 0,3 kPa und 0,7 kPa (2 mTorr und 5 mTorr); und
Liefern von elektrischer Ladung an das eine oder die mehreren drehbaren zylindrischen Ziele zum Spritzablagern des erwünschten Films auf ein Glassubstrat mit großer Oberfläche mit einer Hauptoberfläche, die im Allgemeinen hin zu dem einen oder zu den mehreren drehbaren zylindrischen Zielen ausgerichtet ist, wodurch der erwünschte Film entweder direkt auf die Hauptoberfläche des Substrats oder direkt auf einen zuvor auf die Hauptoberfläche des Substrats abgelagerten Film abgelagert wird,
wobei das Glassubstrat mit großer Oberfläche eine größere Abmessung von wenigstens 30 Zoll (75 cm) aufweist; und
wobei das Liefern der elektrischen Ladung das Liefern der elektrischen Ladung zum Erzeugen eines Gleichstrom-Spritzvorgangs umfasst.

2. Verfahren nach Anspruch 1, wobei das Spritzablagern derart ausgeführt wird, dass der erwünschte Film eine Dicke von zwischen 200 Angström (20 nm) und 3.500 Angström (350 nm), vorzugsweise zwischen 250 Angström (25 nm) und 2.500 Angström (250 nm) und stärker bevorzugt zwischen 350 Angström (35 nm) und 1.800 Angström (180 nm) aufweist.

3. Verfahren nach Anspruch 1, wobei das Spritzablagern derart ausgeführt wird, dass der erwünschte Film Zinn, Niob, Sauerstoff und Stickstoff umfasst, oder derart, dass der erwünschte Film im Wesentlichen aus Zinn, Niob und Sauerstoff besteht.

4. Verfahren nach Anspruch 1, wobei das Spritzablagern derart ausgeführt wird, dass der erwünschte Film zu mehr als etwa 95 Atom-% Zinn und zu weniger als etwa 5 Atom-% Niob umfasst, wobei die Prozentangaben sich auf eine Gesamtzahl von Metallatomen des erwünschten Films beziehen.

5. Verfahren nach Anspruch 1, wobei der erwünschte Film eine Sonnenlichtregelungsbeschichtung definiert oder ein Teil davon ist, wobei der erwünschte Film eine Dicke von zwischen 350 Angström (35 nm) und 1.800 Angström (180 nm) aufweist.

6. Verfahren nach Anspruch 5, wobei sich die Sonnenlichtregelungsbeschichtung auf einer Außenoberfläche einer isolierten Glaseinheit befindet, wobei die Außenoberfläche so angeordnet ist, dass sie zu einer Außenumgebung hin freiliegt.

7. Verfahren nach Anspruch 1, wobei das Glassubstrat mit großer Oberfläche ein Kalknatronglas mit einer Dicke von zwischen etwa 1 mm und 5 mm umfasst.

8. Verfahren nach Anspruch 1, wobei der erwünschte Film über und/oder unter einem Infrarotlicht reflektierenden Film abgelagert wird.

9. Verfahren nach Anspruch 1, wobei das spritzbare Material zu mehr als etwa 95 Atom-% Zinn, vorzugsweise zu mehr als etwa 97 Atom-% Zinn enthält.

## Revendications

1. Procédé de dépôt d'un film souhaité comprenant à la fois de l'étain et du niobium, le procédé comprenant :
l'utilisation d'une ou de plusieurs cibles cylindriques rotatives, ayant chacune un renfort électroconducteur sous la forme d'un tube de métal rigide, chacune des cibles portant un matériau suboxyde pulvérisable constitué essentiellement d'étain, de niobium et d'oxygène, un pourcentage atomique d'étain dans le matériau suboxyde pulvérisable étant supérieur à 90 pour cent ;
le positionnement de l'au moins une cible cylindrique rotative dans une chambre de pulvérisation dotée d'une cavité de pulvérisation contenant une atmosphère gazeuse oxydante à une pression de travail entre 0,3 kPa et 0,7 kPa (2 mtorr et 5 mtorr) ; et
la distribution d'une charge électrique à l'au moins une cible cylindrique rotative pour déposer par pulvérisation ledit film souhaité sur un substrat de verre de grande superficie présentant une surface principale orientée généralement vers l'au moins une cible cylindrique rotative, pour déposer ainsi ledit film souhaité soit directement sur ladite surface principale du substrat, soit directement sur un film déposé précédemment sur ladite surface principale du substrat,
dans lequel le substrat de verre de grande superficie a une dimension principale d'au moins 75 cm (30 pouces) ; et
dans lequel la distribution de la charge électrique comprend la distribution de la charge électrique pour établir un traitement de pulvérisation en C.C.

2. Procédé selon la revendication 1, dans lequel ledit dépôt par pulvérisation est réalisé de sorte que ledit film souhaité ait une épaisseur entre 20 nm (200 angstrôms) et
350 nm (3 500 angstrôms), de préférence entre 25 nm (250 angstrôms) et
250 nm (2 500 angstrôms) et au mieux entre 35 nm (350 angstrôms) et
180 nm (1 800 angstrôms).

3. Procédé selon la revendication 1, dans lequel ledit dépôt par pulvérisation est réalisé de sorte que ledit film souhaité comprenne de l'étain, du niobium, de l'oxygène et de l'azote, ou de sorte que ledit film souhaité soit constitué essentiellement d'étain, de niobium et d'oxygène.

4. Procédé selon la revendication 1, dans lequel ledit dépôt par pulvérisation est réalisé de sorte que ledit film souhaité comprenne plus d'environ 95 pour cent atomique d'étain et moins d'environ 5 pour cent atomique de niobium, lesdits pourcentages se rapportant au nombre total d'atomes de métal dudit film souhaité.

5. Procédé selon la revendication 1, dans lequel le film souhaité définit ou fait partie d'un revêtement de régulation solaire, le film souhaité ayant une épaisseur entre 35 nm (350 angstrôms) et 180 nm (1 800 angstrôms).

6. Procédé selon la revendication 5, dans lequel le revêtement de régulation solaire est situé sur une surface extérieure d'une unité de verre isolée, la surface extérieure étant agencée pour être exposée à un environnement extérieur.

7. Procédé selon la revendication 1, dans lequel le substrat de verre de grande superficie comprend du verre sodocalcique d'épaisseur entre environ 1 mm et 5 mm.

8. Procédé selon la revendication 1, dans lequel le film souhaité est déposé au-dessus et/ou en dessous d'un film réfléchissant les infrarouges.

9. Procédé selon la revendication 1, dans lequel le matériau pulvérisable comporte plus d'environ 95 pour cent atomique d'étain, de préférence plus d'environ 97 pour cent atomique d'étain.
